# EUROPEAN PATENT SPECIFICATION

(11) **EP 1 456 861 B1**
(45) Date of publication and mention of the grant of the patent: **05.10.2011**
(21) Application number: 02793077.5
(22) Date of filing: 18.12.2002
(51) Int. Cl.: H01G 9/20

(54) **A POLYMER GEL HYBRID SOLAR CELL**
EINE POLYMER-GEL-HYBRIDSOLARZELLE
PILE SOLAIRE HYBRIDE A GEL POLYMERE

(30) Priority: 21.12.2001 EP 01130661
(43) Date of publication of application: 15.09.2004
(73) Proprietor: Sony Deutschland GmbH, 10785 Berlin (DE); Sony Corporation, Tokyo 141-0001 (JP)
(72) Inventor: NELLES, Gabriele, Advanced Tech. Center Stuttgart, 70327 Stuttgart (DE); MITEVA, Tzenka, Advanced Tech. Center Stuttgart, 70327 Stuttgart (DE); NODA, Kazuhiro, Advanced Tech. Center Stuttgart, 70327 Stuttgart (DE); YASUDA, Akio, Advanced Tech. Center Stuttgart, 70327 Stuttgart (DE)
(74) Representative: Appelt, Christian W.
(86) International application number: PCT/EP2002/014510
(87) International publication number: WO 2003/054894

(56) References cited:
- EP-A2- 1 164 603
- EP-A2- 1 164 603
- WO-A-00/65617
- WO-A-99/28292
- DE-A- 4 327 114
- BANDARA L R A K ET AL: "DYE SENSITIZED PHOTOELECTROCHEMICAL SOLAR CELLS WITH PEO BASED SOLID POLYMER ELECTROLYTES" WORLD SCIENTIFIC, SINGAPORE, IO, 29 November 1998 (1998-11-29), pages 493-498, XP000826871
- HAUCH A ET AL: "Diffusion in the electrolyte and charge-transfer reaction at the platinum electrode in dye-sensitized solar cells" ELECTROCHIMICA ACTA, ELSEVIER SCIENCE PUBLISHERS, BARKING, GB, vol. 46, no. 22, 1 August 2001 (2001-08-01), pages 3457-3466, XP004298164 ISSN: 0013-4686
- STATHATOS E ET AL: "DYE-SENSITIZED PHOTOELECTROCHEMICAL CELL USING A NANOCOMPOSITE SIO2/POLY(ETHYLENE GLYCOL) THIN FILM AS ELECTROLYTE SUPPORT. CHARACTERIZATION BY TIME-RESOLVED LUMINESCENCE AND CONDUCTIVITY MEASUREMENTS" JOURNAL OF PHYSICAL CHEMISTRY. B, MATERIALS, SURFACES, INTERFACES AND BIOPHYSICAL, WASHINGTON, DC, US, vol. 105, 2001, pages 3486-3492, XP001011482 ISSN: 1089-5647
- REN Y ET AL: "A DYE-SENSITIZED NANOPOROUS TIO2 PHOTOELECTROCHEMICAL CELL WITH NOVEL GEL NETWORK POLYMER ELECTROLYTE" JOURNAL OF APPLIED ELECTROCHEMISTRY, CHAPMAN AND HALL. LONDON, GB, vol. 31, 2001, pages 445-447, XP001002919 ISSN: 0021-891X
- DING L ET AL: "PHOTOVOLTAIC CELLS WITH A CONJUGATED POLYELECTROLYTE" SYNTHETIC METALS, ELSEVIER SEQUOIA, LAUSANNE, CH, vol. 110, no. 2, 3 April 2000 (2000-04-03), pages 133-140, XP000961481 ISSN: 0379-6779

## Description

The invention relates to a polymer gel hybrid solar cell comprising a polymer gel electrolyte.

Single crystal solar cells show energy conversion efficiencies as high as - 25%. Where the Si-based crystals are no longer single crystals but polycrystalline, the highest efficiencies are in the range of ~18%, and with amorphous Si the efficiencies are ~12%. Solar cells based on Si are, however, rather expensive to manufacture, even in the amorphous Si version.

Therefore alternatives have been developed based on organic compounds and/or a mixture of organic and inorganic compounds, the latter type solar cells often being referred to as hybrid solar cells. Organic and hybrid solar cells have proved to be cheaper to manufacture, but seem to have yet comparably low efficiencies even when compared to amorphous Si cells.

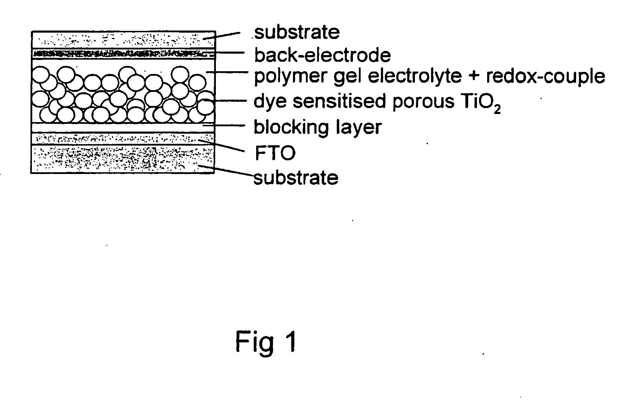

Due to their inherent advantages such as lightweight, low-cost fabrication of large areas, earth-friendly materials, or preparation on flexible substrates, efficient organic devices might prove to be technically and commercially useful 'plastic solar cells'. Recent progress in solar cells based on dye-sensitised nanocrystalline titanium dioxide (porous TiO₂) semiconductor and a liquid redox electrolyte demonstrates the possibility of high energy conversion efficiencies in organic materials (η 11%) [B. O'Regan and M. Grätzel, Nature 353 (1991) 737; data base: Keycentre for Photovoltaic Engineering UNSW]. The basic structure of the hybrid solar cell is illustrated in figure 1.

However, for these solar cells to become widely used, there are still a number of drawbacks to overcome, namely the use of liquid electrolytes for charge transport. Ideally, solid electrolytes should be used to eliminate the possibility of electrolyte leakage in long-term operation, and to eliminate the difficulties in production steps such as injection and sealing of the electrolyte solution. Furthermore, restriction in design of the cell should be reduced, and any shape should be available such as a cylindrical-shape cell, flexible cell, and so on. Nonetheless, the efficiencies of solid-state organic solar cells based on solid-state hole transport materials are low in comparison to the liquid ones (up to 2.5%) [a) Krueger et al., Appl. Phys. Lett. 79, p. 2085 (2001); b) results obtained by present inventors (not shown)], because of the incomplete penetration of hole transport material into, and the detachment of the hole transport layer from, the TiO₂ electrode [S. Tanaka, Japanese Journal of Applied Physics, 40 (2001) 97].

To address those problems, attention is increasingly focusing on developing "quasi solid state" electrolytes, to combine the high efficiency of the liquid cell with the advantages of the solid state cell. There are reports about the addition of polymeric gelling agents in the liquid electrolyte to promote solidification, and about polymer gel electrolytes [M. Matsumoto, H. Miyazaki, K. Matsuhiro, Y. Kumashiro and Y. Takaoka, Solid State Ionics 89 (1996) 263. S. Mikoshiba, H. Sumino, M. Yonetsu and S. Hayase, Proceedings of the 16th European Photovoltaic Solar Energy Conference and Exhibition, Glasgow 2000. W. Kubo, K. Murakoshi, T. Kitamura, Y. Wada, K. Hanabusa, H. Shirai, and S. Yanagida, Chemistry Letters (1998) 1241. A. F. Nogueira, J. R. Durrant, and M. A. De Paoli, Advanced Materials 13 (2001) 826.] There are, however, also problems associated with this approach, since for the formation of suitable gels, some requirements have to be fulfilled such as amorphous character, high melting, etc. Classical gels contain 10% gelator, which in turn decreases the conductivity and the interface contact. Furthermore, many gels cannot be formed in the presence of iodine (which is often part of the redox couple present in the cell), since this is a radical cation catcher. Also some iodides form complexes with the monomers which prevents them from polymerization. This limits the nature of components and the polymerisation techniques to be chosen for forming a chemically cross-linked gel.

Bandara et al., Solid State Ionics: Science & Technology (1998) 493-498 discloses dye sensitised photoelectrochemical solar cells with polyethylene oxide (PEO) - based solid polymer electrolytes. It does not disclose dye sensitised solar cells comprising a polymer gel electrolyte.

DE 43 27 114 A discloses gel-like electrolyte materials for use in photochemical systems, such as photovoltaic cells and solar cells. The electrolyte materials comprise, among other components, gel forming agents, which are present at a concentration of 0.001 to 50 mol %.

Therefore it has been an object of the present invention to avoid the problems described in relation to polymer gel electrolyte solar cells. It has further been an object to provide a hybrid solar cell which has a high energy conversion efficiency. It has also been an object to provide a hybrid solar cell which can be formed into a variety of shapes.

The object is solved by a polymer gel hybrid solar cell comprising a polymer gel electrolyte, wherein the polymer gel electrolyte comprises a polymer, selected from the group comprising homopolymers and copolymers.

Preferably, the homopolymer is linear or non-linear.

In one embodiment, the copolymer is selected from the group comprising statistical copolymers, random copolymers, alternating copolymers, block-copolymers and graft copolymers.

In a preferred embodiment, the polymer is a linear polymer.

More preferably, the polymer is crosslinked.

Preferably, the polymer is not covalently crosslinked.

It is preferred that the polymer is physically crosslinked.

The polymer has a M_{w} > 90,000, preferably a M_{w} > 200,000, more preferably a M_{w} > 400,000.

In one embodiment the polymer is a polyethylene oxide or a derivative thereof.

The polymer constitutes 1 - 10 wt% of the polymer gel electrolyte, preferably 1 - 5 wt% of the polymer gel electrolyte.

In a particularly preferred embodiment the polymer constitutes ~3 wt.% of the polymer gel electrolyte.

In one embodiment, the polymer gel electrolyte has an ionic conductivity > 1 x 10⁻⁶ S/cm, preferably > 1 x 10⁻⁴ S/cm, these values being measured without a redox couple being present in the polymer gel electrolytye. In a particularly preferred embodiment the ionic conductivity is > 1 x 10⁻³ S/cm.

It is preferred that the polymer gel electrolyte further comprises a base and/or a radical scavenger and/or a complexing agent and/or a pinhole-filler and/or a compound reducing the charge recombination.

In one embodiment, the polymer gel electrolyte further comprises an amine. Preferably the amine is a pyridine or a pyridine derivative selected from the group comprising pyridine, 4-tert-butylpyridine, 2-vinylpyridine, and poly(2-vinylpyridine).

In one embodiment the base/radical scavenger/ complexing agent/pinhole-filler/compound reducing the charge recombination is a compound selected from the group comprising compounds having one or several carboxy groups, compounds having one or several amine groups, compounds having one or several carboxy and one or several amine groups, compounds having free electron lone pairs.

Preferably, the polymer gel electrolyte further comprises a redox couple, wherein it is preferred that the redox couple has a low probability to perform recombination reactions with electrons injected into the negatively charged molecules of the electron transport layer (which can be e.g. porous TiO₂). Preferably the redox couple has a redox potential so it cannot be oxidised or reduced by the working electrode. More preferably, the redox couple is I⁻/I₃⁻.

In a preferred embodiment, the redox couple is I⁻/I₃⁻ with the counterion C of I⁻ being selected from the group comprising Li, Na, K, tetrabutylammonium, Cs and DMPII (molten salt) (1-propyl-2,3-dimethylimidazolium iodide (C₈H₁₅N₂₁I).

It is preferred, that the polymer gel electrolyte further comprises a salt, wherein, preferably, the salt is a redox inert salt which, even more preferably, is Li(CF₃SO₂)₂N.

It is preferred that the polymer gel electrolyte further comprises at least one solvent selected from the group comprising propylene carbonate, ethylene carbonate, dimethyl carbonate and acetonitrile. It is to be understood that the solvent is not restricted to the aforementioned ones. One characterising feature of a solvent suitable for the purposes of the present invention is the high permittivity, which supports the dissociation of the components of the redox agent (e.g. iodide).

In one embodiment, the polymer gel electrolyte is ionically and/or electronically conductive.

The polymer gel electrolyte is selected from the group comprising:
- polyethylene oxide, LiClO₄, propylene carbonate and/or ethylene carbonate,
- polyethylene oxide, NH₄ClO₄, propylene carbonate and/or ethylene carbonate,
- polyethylene oxide and/or polymethylmethacrylate, LiClO₄, propylene carbonate and/or ethylene carbonate,
- polyacrylonitrile, Li- and/or Mg trifluoromethanesulfonate, propylene carbonate and/or ethylene carbonate,
- polyethylene oxide and poly(2-vinylpyridine), LiClO₄, 7,7,8,8-tetracyano-1,4-quinodimethane (TCNQ) and/or tetracyanoethylene (TCNE),
- polyethylene oxide and polyaniline, Li(CF₃SO₂)₂N and H(CF₃SO₂)₂N,
- polyaniline grafted with poly(ethyleneoxy)carboxylate,
- polyethylene oxide and poly(3,4-ethylenedioxythiophene)-polystyrenesulfonate (PEDOT-PSS).

The polymer gel hybrid solar cell is dye-sensitised.

In one embodiment, the dye is a ruthenium complex, preferably cis-di(thiocyanato)bis(2,2'-bipyridyl-4,4'-dicarboxylate)ruthenium(II)tetrabutylammonium (Ru(bpy)TBA).

Preferably, the polymer gel electrolyte further comprises nanoparticles, wherein, more preferably, the nanoparticles have an average size in the range from 2 nm - 25 nm.

In one embodiment, the nanoparticles are formed of a semiconductor material.

In one embodiment, the nanoparticles are formed of a material selected from the group comprising TiO₂, ZnO, SnO₂, PbO, WO₃, Fe₂O₃, Bi₂O₃, Sb₂O₃,Nb₂O₅, Ta₂O₅, SrO₂.

In one embodiment the semiconductor nanoparticles are admixed with Au- and/or Ag-nanoparticles.

The object of the invention is also solved by an array of polymer gel hybrid solar cells according to the present invention.

As used herein, the expression "not chemically crosslinked" is used interchangeably with "not covalently crosslinked" and is meant to designate the absence of covalent crosslinking bonds. The term "a polymer is physically crosslinked" is meant to designate a polymer the crosslinking of which between polymer molecules is based on mainly non-covalent interactions, e.g. van der Waals-interactions, hydrophobic interactions, etc.

As used herein the term "homopolymer" is meant to designate a polymer which is derived from one species of monomer. If "A" denotes such a monomer, a homopolymer would be "-A-A-A-A-A..." or -[A]ₙ-, with n indicating the number of repeating units (or monomer units) that are linked together. As used herein, the term "copolymer" is meant to designate a polymer derived from more than one species of monomer. As used herein the term "linear" polymer is meant to designate a polymer that essentially has one chain of monomers linked together and furthermore has only two ends. The term "linear", however, can also be applied to individual regions of a polymer, which then means that such a linear region essentially consists of a chain with two ends. As used herein, the term "non-linear" polymer is meant to designate any polymer that is not linear in the aforementioned sense. In particular, it refers to polymers which are branched polymers, or polymers which are dendritic. As used herein, the term "branched" polymer is meant to designate a polymer having sidechains or branches which are bonded to the main chain at specific branch points. Furthermore the term "non-linear" polymer is also meant to designate "network polymers", which are polymers having a three-dimensional structure in which each chain and/or branch is connected to all other chains and/or branches by a sequence of junction points and other chains/branches. Such network polymers are also sometimes referred to as being "crosslinked", and they are characterized by their crosslink density or degree of crosslinking, which is the number of junction points per unit volume. Usually they are formed by polymerization or by linking together pre-existing linear chains, a process also sometimes referred to as "crosslinking". Furthermore the term "non-linear" polymer also refers to dendritic polymers which are polymers obtained by a process wherein, in each step two or more monomers are linked to each monomer that is already part of the growing polymer molecule. By such a process, in each step, the number of monomer-endgroups grows exponentially, and the resulting structure is a tree-like structure showing a typical "dendritic" pattern.

As used herein, the term "statistical" copolymer is meant to designate a copolymer wherein the sequential distribution of repeating units or monomers obeys known statistical laws. The term "random" copolymer is meant to designate a special type of statistical copolymers wherein the distribution of repeating units or monomers is truly random. More specifically, the term "random" copolymer can designate a specific type of statistical copolymers wherein the sequential distribution of the monomers obeys Bernoullian statistics. As used herein, the term "alternating" copolymer is meant to designate a polymer, wherein different types of repeating units are arranged alternately along the polymer chain. For example, if there are only two different types of monomers, "A" and "B", the alternating copolymer would be "...ABABABAB...". If there are three different types of monomers, "A", "B" and "C", the alternating copolymer would be "...ABCABCABC...". The term "block" copolymer is meant to designate a copolymer wherein there are different blocks each of which is formed of one type of monomer, and which copolymer can be described by the sequence of blocks. For example if one type of block is formed by the monomer "A" and the other type of block is formed by the monomer "B", a block copolymer thereof can be described by the general formula ...-Aₖ-Bₗ-Aₘ-Bₙ-...; k, l, m and n designating the number of monomers in each block. As used herein, the term "graft" polymers is meant to designate branched polymers, which, along their main chain, have side chains with such a length that these side chains can be referred to as polymers themselves. The side chains and the main chain can be chemically identical or different to each other. If they are chemically identical, they are also referred to as "graft polymers", whereas, if they are different to each others, they are referred to as "graft copolymers". The branches and the main chain may be formed of different homopolymers, or each of them, i. e. the branches and the main chain may be formed of different monomers, such that each of them is a copolymer itself.

In the following specific description reference is made to the figures, wherein
Figure 1 shows the basic structure of a hybrid solar cell having I⁻/I₃⁻ as redox couple and a TiO₂ layer as electron transport layer,
Figure 2 shows the electron transfer and transport processes taking place in such a cell,
Figure 2A shows the same processes in a different representation using energy levels,
Figure 3 shows the I/V-curve of a PEO containing hybrid solar cell with 10 nm particle size, 7 µm porous TiO₂ layer thickness,
Figure 4 shows the I/V-curve of PEO plus tert-butylpyridine containing hybrid solar cell, 10 nm particle size, 4 µm porous TiO₂ layer thickness, and
Figure 5 shows the I/V-curves of PEO plus tert-butylpyridine containing hybrid solar cell, 20 nm particle size, 9 µm porous TiO₂ layer thickness, and
Figure 6 shows the I/V-curves of a PEO plus tert-butylpyridine containing hybrid solar cell, 20 nm particle size, 9µm porous TiO₂ layer, and
Figure 6A shows the energy conversion efficiency plotted versus light intensity of the solar cell of figure 6.

The following examples are intended to describe the invention more specifically by way of example and are not intended to limit the scope of the invention.

### Example 1

In one example, polyethylene oxide [PEO, M_{w} 400.000] was used in ethylene carbonate [EC] / propylene carbonate [PC] mixture filled with lithium iodide / iodine [LiI/I₂] and an inert Li salt. In PEO polymer gel electrolyte, the solid polymer matrix of PEO provides dimensional stability to the electrolyte, while the high permittivity of the solvents PC and EC enables extensive dissociation of the Li salts to take place. The low viscosity of PC and EC provides an ionic environment that facilitates high ionic mobility. Such polymer gel electrolytes exhibits high ionic conductivities in excess of 10³ S/cm.

### Example 2

### Solar cell preparation

### Blocking layer

Made by spray pyrolysis: spraying with an atomiser an aerosol dispersion of an organic precursor titanium acetylacetonate (TAA, Aldrich) in ethanol (concentration of 0.2 M) onto structured FTO coated glass substrates (at 450°C) (Geomatic). To get a thin, amorphous, compact layer of TiO₂ (about 30 nm), films are tempered at 500°C in air for 1 hour.

### Nanocrystalline TiO₂ electrode + dye layer

Porous TiO₂ layers are made by screen printing of a paste containing TiO₂ particle of 10 nm or 20 nm diameter respectively (Solaronix Company) on top of the blocking TiO₂ layer (thickness depends on mesh size of screens). To get rid of the organic solvents and surfacatants, and to enable a contact between TiO₂ particles, porous TiO₂ layers are heated up to 85°C for 30 minutes in a first step and sintered at 450°C for ½ hour. After cooling down to 80°C, films are placed into a dye solution in ethanol (5 x 10⁻⁴ M) and stay there overnight in the dark. Afterwards, substrates are rinsed with ethanol and dried several hours in the dark.

### Polymer gel electrolyte

PEO (MW 400.000) was dissolved in THF (30mg/3ml) and stirred with heating up to 75°C for 10 min, cooling down to room temperature. I₂ and LiI (ratio 1:10 by weight; 4.4 mg I₂ (5.7 mM), 44 mg LiI (0.1M)) were dissolved in 0.5 ml THF and mixed with PC/EC (ratio 1:1 by weight, 1 g). Furthermore, bistrifluoromethane sulfonimide lithium (Li((CF₃SO₂)₂N)) was added to the mixture (9.6 mg (7.8 mM)), this concentration yields to an EO:Li ratio of 20:1. Both solutions were mixed in a next step, 50µl were drop casted on top of the dyed porous TiO₂ electrode and kept over night in the dark to allow the evaporation of THF. If applied, tert.-butylpyridine is added to the gel, or the dye-sensitised substrate were placed into a 50% solution in acetonitrile for 15 min before drop casting the polymer electrolyte.

### Back-electrode

Platinum coated FTO substrate (Geomatic) was placed on top as backelectrode to form a sandwich with defined distance of 6 µl (PS foil).

### Measurements

### Photocurrent-voltage characteristic

Photochemical measurements were done using a potentiostat (EG&G Princeton applied research, model 362). As light source, a sulphur lamp (solar 1000), white light, 100 mW/cm² (measured with a powermeter at 530 nm) was used. Reduced light intensity was achieved using neutral density filters.

### Layer thickness

Thickness of the films was measured by a Tencor P-10 profilometer.

### Absorption spectra

Absorption spectra were taken by a Variant UV/Vis spectrometer.

### Example 3

The photovoltaic cell is fabricated by drop casting the ready made gel electrolyte on top of the dye-sensitised porous TiO₂ coated electrode, and sandwiched with a platinum back-electrode.

The layer thickness of the nanocrystalline TiO₂, is varied in the range of 2 to 20 µm, containing particles of 10 or 20 nm in diameter. The illuminated area of the cell is ca. 0.5 - 0.6 cm². As sensitiser dye cis-di(thiocyanato) bis (2,2'-bipyridyl-4,4'-dicarboxylate) ruthenium (II) tetrabutylammonium (Ru(bpy)TBA) is used.

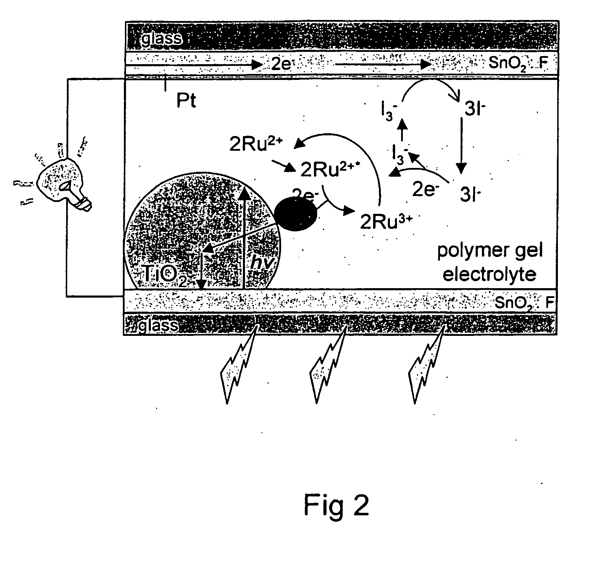

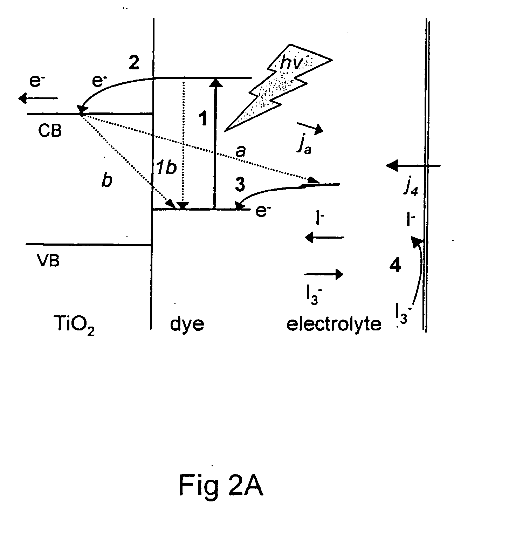

The electron transfer and transport processes in the cell are schematically shown in figure 2.

Light absorbed by the dye molecules injects electrons in to TiO₂ (t - 10⁻¹²s) and holes into the Li/I₂ system (t - 10⁻⁸ s). At the Pt back-electrode, the resulting I₃⁻ species will be reduced to I⁻, undergoing the following redox reactions [D. Kuciauskas, M.S. Freund, H.B. Gray, J.R. Winkler, and N.S. Lewis, J. Phys. Chem. B 105 (2001) 392]

1) Ru(II) + hv → Ru(II)⁺

2) Ru(II)⁺ → Ru(III) + e (cb TiO²)

3) 2Ru(III) + 3 I⁻ → 2Ru(II) + I₃⁻

4) I₃⁻ + 2e⁻→ 3I⁻

The iodide is used to reduce the oxidised dye. It also contributes the ionic charge transport, which is achieved by the I⁻/I₃⁻ redox couple. The negative charge carrier in the electrolyte has the advantage to strongly reduce the probability of the recombination reactions with electrons injected into the porous TiO₂. The presence of mobile ions in the electrolyte, such as Li⁺ from an inert salt like bistrifluoromethane sulfonimide lithium (Li((CF₃SO₂)₂N)), affects the charge transport and can further reduce the recombination reactions by screening photogenerated electrons and holes from each other and by surface adsorption of Li⁺, giving a high amount of positive charge at the surface. A dipole is formed across the Helmholtz layer, which yields an electrical potential drop across the Helmholtz layer that helps to separate the charges and to reduce the recombination. A high amount of I⁻ gives a high photocurrent, the addition of an inert salt raises the photocurrent amplitude, though there is almost no photocurrent with only inert salt [A. Solbrand, A. Henningsson, S. Södergren, H. Lindström, A. Hagfeldt, and S.-E. Lindquist, J. Phys. Chem. B 1999, 103, 1078]

A schematic description of the processes in the cell is shown in Fig. 2A, wherein 1 denotes photon absorption, 2 denotes electron injection, 3 denotes dye reduction, 4 denotes I₃⁻ reduction, a and b electronic recombination, VB and CB denote valence band and conduction band, respectively. The relative positions of the energy levels are roughly to scale.

The right combination of all components in the cells is a crucial point. In general, the use of a semiconductor with larger band gap, and with low electron affinity in the electrolyte is favored, as well a semiconductor with hight density of states in the CB.

### Example 4

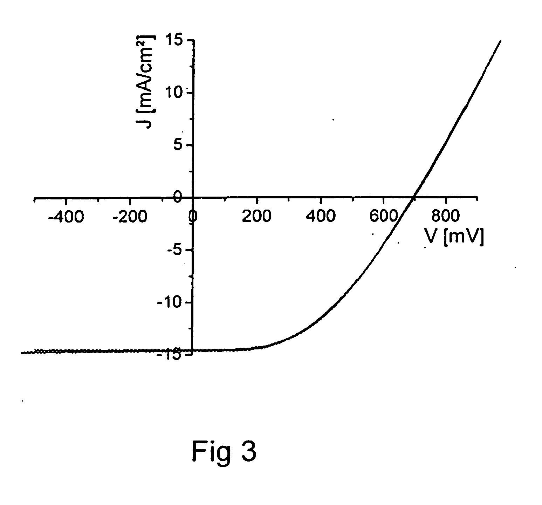

Photochemical measurements of the polymer gel hybrid solar cells consisting of PEO polymer gel electrolyte and 7 µm porous TiO₂ layer of 10 nm particles, gave an open circuit voltage (V_{oc}) of 693 mV, short circuit current (J_{JC}) of 14.4 mA/cm², fill factor (FF) or 47 %, and an overall energy conversion efficiency (η) of 4.7 % with white light of Am 1.5 (100 mW/cm², standard for solar cell characterisation). The IN-curves are shown in figure 3.

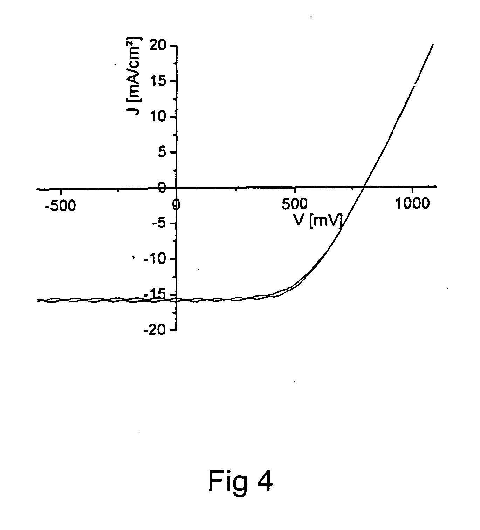

A major factor limiting the energy conversion efficiencies is the low photovoltage. Here charge recombination at the TiO₂ / electrolyte interface plays a significant role. Small molecules like derivatives of benzoic acid or pyridine, adsorb to TiO₂ and block the free interface, which results in a reduced recombination [J. Krüger, U. Bach, and M. Grätzel, Advanced Materials 12 (2000) 447, S.Y. Huang, G. Schlichthörl, A.J. Nozik, M. Grätzel and A.J. Frank, J. Phys. Chem. B. 1997, 101, 2576]. Adding tert.-butylpyridine to the polymer gel electrolyte improved both V_{oc} and η of the polymer gel hybrid solar cell significantly. The corresponding cells gave V_{oc} of 800 mV, Jsc of 16 mA/cm², FF of 55 %, and η of 7 % with 100 mW/cm² (also see Fig. 4).

A further important parameter in the dye-sensitised solar cells seems to be pore size, which is determined by the diameter of the nanocrystalline TiO₂ particles, and which also influences the penetration behaviour of the polymer gel electrolyte into the pores. To investigate this influence a paste was used containing particles of 20 nm diameters. The roughness of the layers consisting of the 20 nm particles is higher than the one of the 10 nm particles containing layer. In 4 µl porous TiO₂ layers, the pore size of the 20 nm particles containing layer is expected to be larger and the surface area is expected to be smaller. This should have an influence on the cell performance.

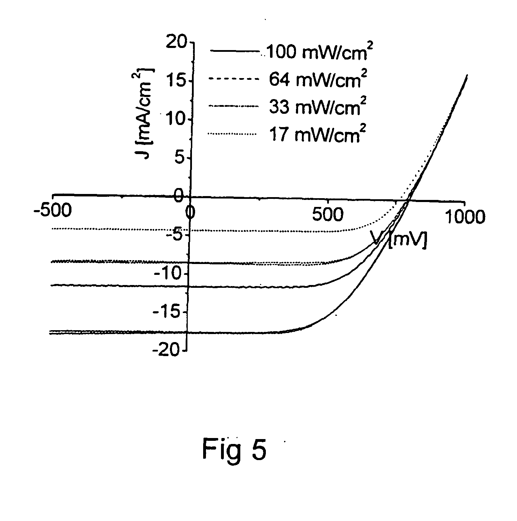

Photochemical measurement of a solar cell consisting of a 9 µl porous TiO₂ layer of 20 nm particle and tert.-butylpyridine at the interface showed V_{oc} of 800 mV, J_{SC} of 17.8 mA/cm², FF of 55 %, and η of 7.8 % with 100 mW/cm². Different from the Si-based solar cells, dye-sensitised TiO₂ solar cells do not show a linear dependence of η on the white light intensity. Depending on the electrolyte, they show a maximum in η around 20 mW/cm². The origin of this phenomena might be explained by an increase in the device serial resistance R₆, induced by a higher charge carrier density at the TiO₂ / electrolyte interface arising primarily from the limited ionic conductivity. Measurements with light intensity of 17 mW/cm² gave V_{oc} of 760 mV, Jsc of 4.33 mA/cm², FF of 70 % and η of 13.6 % (also see Fig. 5).

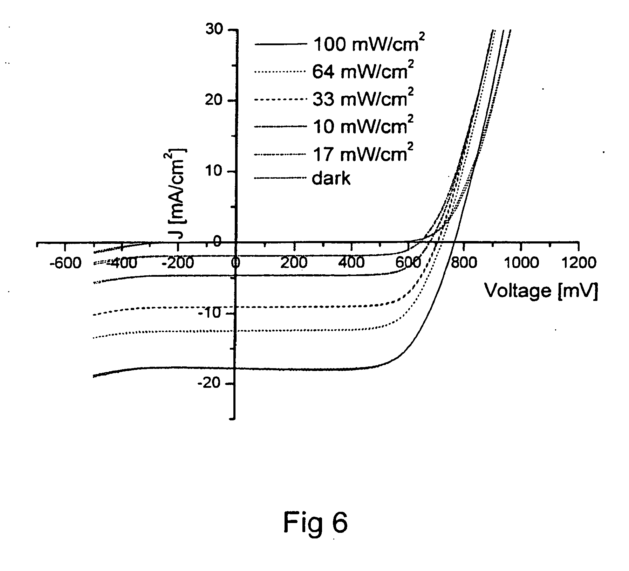

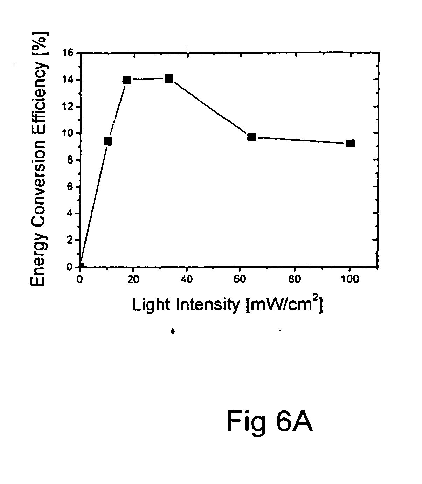

Mobility of the redox agent has an influence on the regeneration of the dye. To enable a fast regeneration, the iodide should be as mobile as possible. The size of the corresponding cation has an influence on the anion mobility; the larger the cation, the higher the dissociation, the higher the mobility of I⁻. Using NaI rather than LiI resulted in an increase in FF and therefore in η. Photochemical measurement of a solar cell consisting of a 9 µm porous TiO₂ layer of 20 nm particle and tert-butylpyridine showed V_{oc} of 765 mV, J_{sc} of 17.8 mA/cm², FF of 68%, and η of 9.2% with 100 mW/cm². Measurements with light intensity of 33 mW/cm² gave V_{oc} of 705 mV, J_{sc} of 9 mA/cm², FF of 73% and η of 14.1% (Fig. 6 and 6A). Those values are, as of the filing date of this application, to the knowledge of the inventors, the best reported ever for polymer gel hybrid solar cells.

The preparation techniques applied in the type of solar cell described in the present application can be used for large area devices. To keep the serial resistant as small as possille, small areas are of advantage. Single cells may have an area of 0.1 - 100 cm², preferably 0.1 -30 cm², more preferably 0.1 - 10 cm², even more preferably 0.1 - 5.0 cm², most preferably 0.1 - 1.0 cm². In addition, arrays of solar cells, either all in serial connection, or partly in parallel and serial connection or all in parallel connection are envisioned. The applied design depends on the requirements - higher V_{oc} or J _{sc}.

## Claims

1. A dye sensitised solar cell comprising a polymer gel electrolyte, wherein the polymer gel electrolyte comprises a polymer, selected from the group comprising homopolymers and copolymers,
**characterized in that** the polymer has a M_{w} > 90,000 and constitutes 1 - 10 wt% of the polymer gel electrolyte,
wherein the polymer gel electrolyte is selected from the group consisting of:
- polyethylene oxide, LiClO₄, propylene carbonate and/or ethylene carbonate,
- polyethylene oxide, NH₄ClO₄, propylene carbonate and/or ethylene carbonate,
- polyethylene oxide and/or polymethylmethacrylate, LiClO_{4,} propylene carbonate and/or ethylene carbonate,
- polyacrylonitrile, Li- and/or Mg trifluoromethanesulfonate, propylene carbonate and/or ethylene carbonate,
- polyethylene oxide and poly(2-vinylpyridine), LiClO₄, 7,7,8,8-tetracyano-1,4-quinodimethane and/or tetracyanoethylene (TCNE),
- polyethylene oxide and polyaniline, Li(CF₃SO₂)₂N and H(CF₃SO₂)₂N,
- polyaniline grafted with poly(ethyleneoxy)carboxylate,
- polyethylene oxide and poly(3,4-ethylenedioxythiophene)-polystyrenesulfonate (PEDOT-PSS).

2. The dye sensitised solar cell according to claim 1, wherein the homopolymer is linear or non-linear.

3. The dye sensitised solar cell according to claim 1, wherein the copolymer is selected from the group comprising statistical copolymers, random copolymers, alternating copolymers, block-copolymers and graft copolymers.

4. The dye sensitised solar cell according to any of the foregoing claims, wherein the polymer is a linear polymer.

5. The dye sensitised solar cell according to any of the foregoing claims, wherein the polymer is crosslinked.

6. The dye sensitised solar cell according to claim 5, wherein the polymer is not covalently crosslinked.

7. The dye sensitised solar cell according to claims 5 - 6, wherein the polymer is physically crosslinked.

8. The dye sensitised solar cell according to any of the foregoing claims, wherein the polymer has a M_{w} > 200,000.

9. The dye sensitised solar cell according to claim 8, wherein the polymer has a M_{w} > 400,000.

10. The dye sensitised solar cell according to any of the foregoing claims, wherein the polymer constitutes 1-5 wt% of the polymer gel electrolyte.

11. The dye sensitised solar cell according to any of the foregoing claims, wherein the polymer gel electrolyte has an ionic conductivity > 1 x 10⁻⁶ S/cm, the value being measured without a redox couple being present in the polymer gel electrolyte.

12. The dye sensitised solar cell according to claim 11, wherein the polymer gel electrolyte has an ionic conductivity > 1 x 10⁻³ S/cm.

13. The dye sensitised solar cell according to any of the foregoing claims, wherein the polymer gel electrolyte further comprises a base and/or a radical scavenger and/or a complexing agent and/or a compound reducing the charge recombination.

14. The dye sensitised solar cell according to claim 13 and/or any of the foregoing claims, wherein the polymer gel electrolyte further comprises an amine.

15. The dye sensitised solar cell according to claim 14, wherein the amine is a pyridine or a pyridine derivative selected from the group comprising pyridine, 4-tert-butylpyridine, 2-vinylpyridine, and poly(2-vinylpyridine)

16. The dye sensitised solar cell according to claim 13, wherein the base/radical scavenger/ complexing agent compound reducing the charge recombination is a compound selected from the group comprising compounds having one or several carboxy groups, compounds having one or several amine groups, compounds having one or several carboxy and one or several amine groups, and compounds having free electron lone pairs.

17. The dye sensitised solar cell according to any of the foregoing claims, wherein the polymer gel electrolyte further comprises a redox couple.

18. The dye sensitised solar cell according to claim 17, wherein the redox couple is I⁻/I₃⁻.

19. The dye sensitised solar cell according to claim 18, wherein the redox couple is I⁻/I₃⁻ with the counterion C of I⁻ being selected from the group comprising Li, Na, K, tetrabutylammonium, Cs and 1-propyl-2,3-dimethylimidazolium iodide (C₈H₁₅N₂I) (molten salt).

20. The dye sensitised solar cell according to any of the foregoing claims, wherein the polymer gel electrolyte further comprises a salt.

21. The dye sensitised solar cell according to claim 20, wherein the salt is Li(CF₃SO₂)₂N.

22. The dye sensitised solar cell according to any of the foregoing claims, wherein the polymer gel electrolyte is ionically and/or electronically conductive.

23. The dye sensitised solar cell according to any of the foregoing claims, wherein the dye is a ruthenium complex.

24. The dye sensitised solar cell according to any of the foregoing claims, wherein the polymer gel electrolyte further comprises nanoparticles.

25. The dye sensitised solar cell according to claim 24, wherein the nanoparticles have an average size in the range from 2 nm - 25 nm.

26. The dye sensitised solar cell according to any of claims -24-25, wherein the nanoparticles are formed of a semiconductor material.

27. An array of dye sensitised solar cells according to any of the foregoing claims.

## Patentansprüche

1. Farbstoff-sensibilisierte Solarzelle, umfassend einen Polymer-Gel-Elektrolyten, wobei der Polymer-Gel-Elektrolyt ein Polymer umfasst, ausgewählt aus der Gruppe, umfassend Homopolymere und Copolymere,
**dadurch gekennzeichnet, dass** das Polymer ein M_{w} > 90.000 hat und 1-10 Gew.% des Polymer-Gel-Elektrolyts ausmacht,
wobei der Polymer-Gel-Elektrolyt ausgewählt ist aus der Gruppe, bestehend aus:
- Polyethylenoxid, LiClO₄, Propylencarbonat und/oder Ethylencarbonat,
- Polyethylenoxid, NH₄ClO₄, Propylencarbonat und/oder Ethylencarbonat,
- Polyethylenoxid und/oder Polymethylmethacrylat, LiClO₄, Propylencarbonat und/oder Ethylencarbonat,
- Polyacrylonitril, Li- und/oder Mg-Trifluormethansulfonat, Propylencarbonat und/oder Ethylencarbonat,
- Polyethylenoxid und Poly(2-vinylpyridin), LiClO₄, 7,7,8,8-Tetracyano-1,4-Quinodimethan und/oder Tetracyanoethylen (TCNE),
- Polyethylenoxid und Polyanilin, Li(CF₃SO₂)₂N und H(CF₃SO₂)₂N,
- Polyanilin, das mit Poly(ethylenoxy)carboxylat gepfropft ist,
- Polyethylenoxid und Poly(3,4-Ethylendioxythiophen)-polystyrolsulfonat (PEDOT-PSS).

2. Farbstoff-sensibilisierte Solarzelle nach Anspruch 1, wobei das Homopolymer linear oder nicht-linear ist.

3. Farbstoff-sensibilisierte Solarzelle nach Anspruch 1, wobei das Copolymer ausgewählt ist aus der Gruppe, umfassend statistische Copolymere, Zufalls-Copolymere, alternierende Copolymere, Block-Copolymere und Pfropf-Copolymere.

4. Farbstoff-sensibilisierte Solarzelle nach einem der vorangehenden Ansprüche, wobei das Polymer ein lineares Polymer ist.

5. Farbstoff-sensibilisierte Solarzelle nach einem der vorangehenden Ansprüche, wobei das Polymer quervernetzt ist.

6. Farbstoff-sensibilisierte Solarzelle nach Anspruch 5, wobei das Polymer nicht kovalent quervernetzt ist.

7. Farbstoff-sensibilisierte Solarzelle nach den Ansprüchen 5-6, wobei das Polymer physisch-quervernetzt ist.

8. Farbstoff-sensibilisierte Solarzelle nach einem der vorangehenden Ansprüche, wobei das Polymer ein M_{w} > 200.000 hat.

9. Farbstoff-sensibilisierte Solarzelle nach Anspruch 8, wobei das Polymer ein M_{w} > 400.000 hat.

10. Farbstoff-sensibilisierte Solarzelle nach einem der vorangehenden Ansprüche, wobei das Polymer 1-5 Gew.% des Polymer-Gel-Elektrolyts ausmacht.

11. Farbstoff-sensibilisierte Solarzelle nach einem der vorangehenden Ansprüche, wobei der Polymer-Gel-Elektrolyt eine Ionenleitfähigkeit > 1 x 10⁻⁶ S/cm hat, wobei der Wert in Abwesenheit eines Redox-Paars in dem Polymer-Gel-Elektrolyt gemessen wird.

12. Farbstoff-sensibilisierte Solarzelle nach Anspruch 11, wobei der Polymer-Gel-Elektrolyt eine Ionenleitfähigkeit > 1 x 10⁻³ S/cm hat.

13. Farbstoff-sensibilisierte Solarzelle nach einem der vorangehenden Ansprüche, wobei der Polymer-Gel-Elektrolyt weiterhin eine Base und/oder einen Radikalfänger und/oder ein Komplexmittel und/oder eine Verbindung, die die Ladungsrekombination verringert, umfasst.

14. Farbstoff-sensibilisierte Solarzelle nach Anspruch 13 und/oder einem der vorangehenden Ansprüche, wobei der Polymer-Gel-Elektrolyt weiterhin ein Amin umfasst.

15. Farbstoff-sensibilisierte Solarzelle nach Anspruch 14, wobei das Amin Pyridin oder ein Pyridinderivat ist, ausgewählt aus der Gruppe, umfassend Pyridin, 4-tert-Butylpyridin, 2-Vinylpyridin und Poly(2-vinylpyridin).

16. Farbstoff-sensibilisierte Solarzelle nach Anspruch 13, wobei die Base/Radikalfänger/Komplexmittel/Verbindung, die die Ladungsrekombination verringert, eine Verbindung ist, ausgewählt aus der Gruppe, umfassend Verbindungen mit einer oder mehreren Carboxygruppen, Verbindungen mit einer oder mehreren Amingruppen, Verbindungen mit einer oder mehreren Carboxy- und einer oder mehreren Amingruppen, und Verbindungen mit freien einsamen Elektronenpaaren.

17. Farbstoff-sensibilisierte Solarzelle nach einem der vorangehenden Ansprüche, wobei der Polymer-Gel-Elektrolyt weiterhin ein Redox-Paar umfasst.

18. Farbstoff-sensibilisierte Solarzelle nach Anspruch 17, wobei das Redox-Paar I⁻/I₃⁻ ist.

19. Farbstoff-sensibilisierte Solarzelle nach Anspruch 18, wobei das Redox-Paar I⁻/I₃⁻ ist, wobei das Gegenion C von I⁻ ausgewählt ist aus der Gruppe, umfassend Li, Na, K, Tetrabutylammonium, Cs und 1-Propyl-2,3-Dimethylimidazoliodid (C₈H₁₅N₂I) (geschmolzenes Salz).

20. Farbstoff-sensibilisierte Solarzelle nach einem der vorangehenden Ansprüche, wobei der Polymer-Gel-Elektrolyt weiterhin ein Salz umfasst.

21. Farbstoff-sensibilisierte Solarzelle nach Anspruch 21, wobei das Salz Li(CF₃SO₂)₂N ist.

22. Farbstoff-sensibilisierte Solarzelle nach einem der vorangehenden Ansprüche, wobei der Polymer-Gel-Elektrolyt ionisch und/oder elektronisch leitend ist.

23. Farbstoff-sensibilisierte Solarzelle nach einem der vorangehenden Ansprüche, wobei der Farbstoff ein Rutheniumkomplex ist.

24. Farbstoff-sensibilisierte Solarzelle nach einem der vorangehenden Ansprüche, wobei der Polymer-Gel-Elektrolyt weiterhin Nanopartikel umfasst.

25. Farbstoff-sensibilisierte Solarzelle nach Anspruch 24, wobei die Nanopartikel eine durchschnittliche Größe im Bereich von 2 nm - 25 nm haben.

26. Farbstoff-sensibilisierte Solarzelle nach einem der Ansprüche 24-25, wobei die Nanopartikel aus einem Halbleitermaterial gebildet sind.

27. Eine Anordnung von Farbstoff-sensibilisierten Solarzellen nach einem der vorangehenden Ansprüche.

## Revendications

1. Cellule solaire sensibilisée par un colorant comprenant un électrolyte sous forme de gel polymère, dans laquelle l'électrolyte sous forme de gel polymère comprend un polymère, choisi dans le groupe comprenant les homopolymères et les copolymères,
**caractérisée en ce que** le polymère a une M_{w} > 90 000 et représente de 1 à 10 % en poids de l'électrolyte sous forme de gel polymère,
l'électrolyte sous forme de gel polymère étant choisi dans le groupe constitué par :
- l'oxyde de polyéthylène, LiClO_{4,} le carbonate de propylène et/ou le carbonate d'éthylène,
- l'oxyde de polyéthylène, NH₄ClO₄, le carbonate de propylène et/ou le carbonate d'éthylène,
- l'oxyde de polyéthylène et/ou le polyméthacrylate de méthyle, LiClO₄, le carbonate de propylène et/ou le carbonate d'éthylène,
- le polyacrylonitrile, le trifluorométhanesulfonate de Li et/ou de Mg, le carbonate de propylène et/ou le carbonate d'éthylène,
- l'oxyde de polyéthylène et la poly(2-vinylpyridine), LiClO₄, le 7,7,8,8-tétracyano-1,4-quinodiméthane et/ou le tétracyanoéthylène (TCNE),
- l'oxyde de polyéthylène et la polyaniline, Li(CF₃SO₂)₂N et H(CF₃SO₂)₂N,
- la polyaniline greffée avec un carboxylate de poly(éthylèneoxy),
- l'oxyde de polyéthylène et le poly(3,4-éthylène-dioxythiophène)-sulfonate de polystyrène (PEDOT-PSS).

2. Cellule solaire sensibilisée par un colorant selon la revendication 1, dans laquelle l'homopolymère est linéaire ou non linéaire.

3. Cellule solaire sensibilisée par un colorant selon la revendication 1, dans laquelle le copolymère est choisi dans le groupe comprenant les copolymères statistiques, les copolymères aléatoires, les copolymères alternés, les copolymères séquencés et les copolymères greffés.

4. Cellule solaire sensibilisée par un colorant selon l'une quelconque des revendications précédentes, dans laquelle le polymère est un polymère linéaire.

5. Cellule solaire sensibilisée par un colorant selon l'une quelconque des revendications précédentes, dans laquelle le polymère est réticulé.

6. Cellule solaire sensibilisée par un colorant selon la revendication 5, dans laquelle le polymère n'est pas réticulé par des liaisons covalentes.

7. Cellule solaire sensibilisée par un colorant selon les revendications 5 et 6, dans laquelle le polymère est physiquement réticulé.

8. Cellule solaire sensibilisée par un colorant selon l'une quelconque des revendications précédentes, dans laquelle le polymère a une M_{w} > 200 000.

9. Cellule solaire sensibilisée par un colorant selon la revendication 8, dans laquelle le polymère a une M_{w} > 400 000.

10. Cellule solaire sensibilisée par un colorant selon l'une quelconque des revendications précédentes, dans laquelle le polymère représente de 1 à 5 % en poids de l'électrolyte sous forme de gel polymère.

11. Cellule solaire sensibilisée par un colorant selon l'une quelconque des revendications précédentes, dans laquelle l'électrolyte sous forme de gel polymère a une conductivité ionique > 1 x 10⁻⁶ S/cm, la valeur étant mesurée sans couple redox présent dans l'électrolyte sous forme de gel polymère.

12. Cellule solaire sensibilisée par un colorant selon la revendication 11, dans laquelle l'électrolyte sous forme de gel polymère a une conductivité ionique > 1 x 10⁻³ S/cm.

13. Cellule solaire sensibilisée par un colorant selon l'une quelconque des revendications précédentes, dans laquelle l'électrolyte sous forme de gel polymère comprend, en outre, une base et/ou un piégeur de radicaux et/ou un complexant et/ou un composé réduisant la recombinaison des charges.

14. Cellule solaire sensibilisée par un colorant selon la revendication 13 et/ou selon l'une quelconque des revendications précédentes, dans laquelle l'électrolyte sous forme de gel polymère comprend, en outre, une amine.

15. Cellule solaire sensibilisée par un colorant selon la revendication 14, dans laquelle l'amine est une pyridine ou un dérivé de pyridine choisi dans le groupe comprenant la pyridine, la 4-tert-butylpyridine, la 2-vinylpyridine, et la poly(2-vinylpyridine).

16. Cellule solaire sensibilisée par un colorant selon la revendication 13, dans laquelle la base/le piégeur de radicaux/le complexant/le composé réduisant la recombinaison des charges est un composé choisi dans le groupe comprenant les composés ayant un ou plusieurs groupes carboxy, les composés ayant un ou plusieurs groupes amine, les composés ayant un ou plusieurs groupes carboxy et un ou plusieurs groupes amine, et les composés ayant des doublets électroniques libres.

17. Cellule solaire sensibilisée par un colorant selon l'une quelconque des revendications précédentes, dans laquelle l'électrolyte sous forme de gel polymère comprend, en outre, un couple redox.

18. Cellule solaire sensibilisée par un colorant selon la revendication 17, dans laquelle le couple redox est I⁻/I₃⁻.

19. Cellule solaire sensibilisée par un colorant selon la revendication 18, dans laquelle le couple redox est I⁻/I₃⁻, le contre-ion C de I⁻ étant choisi dans le groupe comprenant Li, Na, K, tétrabutylammonium, Cs et iodure de 1-propyl-2,3-diméthylimidazolium (C₈H₁₅N₂I) (sel fondu).

20. Cellule solaire sensibilisée par un colorant selon l'une quelconque des revendications précédentes, dans laquelle l'électrolyte sous forme de gel polymère comprend, en outre, un sel.

21. Cellule solaire sensibilisée par un colorant selon la revendication 21, dans laquelle le sel est Li(CF₃SO₂)₂N.

22. Cellule solaire sensibilisée par un colorant selon l'une quelconque des revendications précédentes, dans laquelle l'électrolyte sous forme de gel polymère est ioniquement et/ou électroniquement conducteur.

23. Cellule solaire sensibilisée par un colorant selon l'une quelconque des revendications précédentes, dans laquelle le colorant est un complexe de ruthénium.

24. Cellule solaire sensibilisée par un colorant selon l'une quelconque des revendications précédentes, dans laquelle l'électrolyte sous forme de gel polymère comprend, en outre, des nanoparticules.

25. Cellule solaire sensibilisée par un colorant selon la revendication 24, dans laquelle les nanoparticules ont une taille moyenne dans la plage de 2 à 25 nm.

26. Cellule solaire sensibilisée par un colorant selon l'une quelconque des revendications 24 à 25, dans laquelle les nanoparticules sont formées à partir d'un matériau semiconducteur.

27. Réseau de cellules solaires sensibilisées par un colorant selon l'une quelconque des revendications précédentes.
